(19)

Europäisches
Patentamt
European
Patent Office
Office européen
des brevets

(11) **EP 3 460 573 A1**

(12) **EUROPEAN PATENT APPLICATION**

(43) Date of publication:
**27.03.2019 Bulletin 2019/13**

(51) Int Cl.:
*G03F 7/004* *(2006.01)*     *G03F 7/039* *(2006.01)*

(21) Application number: **18162333.1**

(22) Date of filing: **16.03.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.09.2017   JP 2017180938
14.03.2018   JP 2018046574**

(71) Applicant: **KABUSHIKI KAISHA TOSHIBA
Minato-ku
Tokyo
105-8001 (JP)**

(72) Inventors:
• **NAKAMURA, Hiroko
Tokyo, 105-8001 (JP)**

• **ASAKAWA, Koji
Tokyo, 105-8001 (JP)**
• **KIHARA, Naoko
Kanagawa (JP)**
• **YOSHIMURA, Reiko
Tokyo, 105-8001 (JP)**
• **YAMADA, Ko
Tokyo, 105-8001 (JP)**

(74) Representative: **Moreland, David
Marks & Clerk LLP
Aurora
120 Bothwell Street
Glasgow G2 7JS (GB)**

Remarks:
A request for correction ...... has been filed pursuant to Rule 139 EPC. A decision on the request will be taken during the proceedings before the Examining Division (Guidelines for Examination in the EPO, A-V, 3.).

(54)   **PHOTOSENSITIVE COMPOSITION AND METHOD OF MANUFACTURING GRAPHENE DEVICE**

(57)   A photosensitive composition of an arrangement includes: a resin containing at least one selected from polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and a photo acid generator which generates an acid by being irradiated with light, of which a wavelength is not less than 300 nm nor more than 500 nm, or KrF excimer laser light, the photo acid generator containing a substance that has a naphthalene ring or a benzene ring and in which at least one carbon atom of the naphthalene ring or the benzene ring is bonded to a bulky group.

EP 3 460 573 A1

## Description

## FIELD

Embodiments described herein relate generally to a photosensitive composition and a method of manufacturing a graphene device.

## BACKGROUND

Graphene can be fabricated by the physical exfoliation of graphite, and ever since its unique properties were experimentally confirmed, it has been drawing attention and research and development have been made on its various applications. For example, because of its high mobility, graphene has been drawing attention as a high-speed communication device, and studies have been made on its application to an optical frequency mixer, an optical communication modulator, a photodetector, further an oscillator, and the like as optical communication devices. Studies have also been made on a switching element that achieves an on/off current value ratio of $10^5$ or more. Another feature of graphene is that the number of its carriers is easily changed by doping. In graphene, due to the absence of a band gap, a potential change or molecular adsorption to the surface of graphene causes charge transfer to easily change the number of holes and electrons serving as the carriers. Graphene has drawing attention also as a gas sensor or the like utilizing this feature.

On a research level, since only a small number of devices need to be fabricated, electron beam lithography using an EB resist which contains polymethyl methacrylate (PMMA) as a base resin and is photosensitive to an electron beam is employed for graphene patterning. However, this requires a lot of time to fabricate the devices and thus is not suitable for the mass production of a large number of devices. On the other hand, the low-cost fabrication of a large number of graphene devices is enabled by using a resist whose exposure light is UV light with a wavelength of 300 nm or more (a g-line with a 436 nm wavelength, and i-line with a 365 nm wavelength, or the like) of a halogen lamp or a mercury lamp) or KrF excimer laser light with a 248 nm wavelength.

As the resist sensitive to the UV light with a 300 nm wavelength or more, a novolac resist is typically used. This contains a novolac resin as a base resin and a photosensitizer. The photosensitizer inhibits the novolac resin from dissolving, but when irradiated with the UV light with a 300 nm wavelength or more, the photosensitizer converts into indene carboxylic acid to be hydrophilic, which causes the novolac resin to decompose and dissolve in a developing solution, so that patterning can be done. However, the novolac resin and the photosensitizer each contain a benzene ring and thus are readily π-π stacked with graphene. Accordingly, if the novolac resist is used in the fabrication of a graphene device, the resist cannot be completely removed, and after being processed, contaminates the graphene, causing a problem of degrading the performance of the graphene device.

As a KrF resist adapted to the KrF excimer laser light with a 248 nm wavelength, one containing polyhydroxystyrene (PHS) as a base resin and additionally containing an about several % photo acid generator is used. As the photo acid generator, salt of triphenyl sulfonium hexafluorophosphate which generates an acid when irradiated with the KrF excimer laser light is used, for instance. A polymer chain of PHS includes a portion in which a phenyl group of PHS is protected with a protecting group (for example, a butoxycarbonyl group). The acid generated from the photo acid generator due to the light exposure causes a reaction to remove the protecting group, and the resultant PHS becomes alkali-soluble. Consequently, solubility in an alkali developing solution increases, so that patterning can be done. PHS and a triphenyl sulfonium ion each also contain an aromatic ring (benzene ring). Therefore, the KrF resist cannot be completely removed at the time of the processing of graphene and thus also has a problem of degrading the performance of a graphene device.

## SUMMARY

A problem to be solved by the aspects of the invention is to provide a photosensitive composition as a resist used in, for example, the processing of graphene, that is prevented from being π-π stacked with the graphene, making it possible to reduce the contamination, performance degradation, and so on of the graphene, and a method of manufacturing a graphene device using the same.

According to the aspects of the present invention, there is provided a photosensitive composition as a resist used in, for example, the processing of graphene, that is prevented from being π-π stacked with the graphene, making it possible to reduce the contamination, performance degradation, and so on of the graphene.

## BRIEF DESCRIPTION OF THE DRAWINGS

Fig. 1 is a view illustrating basic structures of a first example of a base resin in a photoresist of an arrangement.
Fig. 2 is a view illustrating examples of a unit having a protecting group introduced to the base resin illustrated in Fig. 1.
Fig. 3 is a view illustrating examples of the unit having the protecting group introduced to the base resin illustrated in Fig. 1.
Fig. 4 is a view illustrating examples of a unit having a lactone introduced to the base resin illustrated in Fig. 1.
Fig. 5 is a view illustrating a second example of the resin in the photoresist of the arrangement.

Fig. 6 is a view illustrating examples of a protecting group introduced to the base resin illustrated in Fig. 5.

Fig. 7 is a view illustrating a third example of the resin in the photoresist of the arrangement.

Fig. 8 is a view illustrating examples of a fourth example of the resin in the photoresist of the arrangement.

Fig. 9 is a view illustrating another example of the fourth example of the resin in the photoresist of the arrangement.

Fig. 10 is a view illustrating still another example of the resin in the photoresist of the arrangement.

Fig. 11 is a view illustrating a structure example of a photo acid generator as a comparative example in which π-π stacking with graphene occurs.

Fig. 12 is a view illustrating a first example of the photo acid generator in the photoresist of the arrangement.

Fig. 13 is a view illustrating a second example of the photo acid generator in the photoresist of the arrangement.

Fig. 14 is a view illustrating a third example of the photo acid generator in the photoresist of the arrangement.

Fig. 15 is a view illustrating a fourth example of the photo acid generator in the photoresist of the arrangement.

Fig. 16 is a view illustrating a fifth example of the photo acid generator in the photoresist of the arrangement.

Figs. 17A to 17C are plane views illustrating manufacturing steps of a graphene device of an arrangement.

Figs. 18A to 18B are graphs illustrating an I-V characteristic of a graphene device (GFET) fabricated in an example 1, and that of a graphene device (GFET) of a comparative example 1 as a comparison.

Fig. 19 is a view illustrating an acid generating used in a comparative example 2.

Figs. 20A to 20B are graphs illustrating an I-V characteristic of a graphene device (GFET) fabricated in an example 4, and that of a graphene device (GFET) of a comparative example 2 as a comparison.

Figs. 21A to 22B are graphs illustrating an effective mobility of a graphene in the graphene device (GFET) of the example 4 and the comparative example 2 calculated from the I-V characteristics of Figs. 20A and 20B.

## DETAILED DESCRIPTION

According to the arrangements of the invention, there is provided a photosensitive composition that includes: a resin containing at least one selected from the group consisting of polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and a photo acid generator which generates an acid by being irradiated with light with a wavelength of not less than 300 nm nor more than 500 nm or KrF excimer laser light, the photo acid generator containing a substance which has a naphthalene ring or a benzene ring and in which at least one carbon atom of the naphthalene ring or the benzene ring is bonded to a bulky group.

A photoresist (photosensitive composition) of an arrangement and a method of manufacturing a graphene device using the same will be hereinafter described with reference to the drawings. Note that, in each arrangement, substantially the same constituent parts are denoted by the same reference signs and a description thereof will be partly omitted in some case. The drawings are schematic, and a relation of thickness and planar dimension of each part, a thickness ratio among parts, and so on are sometimes different from actual ones.

(First Embodiment/Photoresist (Photosensitive Composition))

The photoresist (photosensitive composition) of the arrangement is a chemically amplified resist and is basically composed of a resin and a photo acid generator. In the patterning of graphene or a film formed thereon, the photoresist of the arrangement enables the pattern formation by the exposure with the light, of which a wavelength is not less than 300 nm nor more than 500 nm, or KrF excimer laser light and the development while reducing the contamination, property degradation, and so on of the graphene caused by π-π stacking. In the photoresist of the arrangement, a hydrophilic portion of the resin is partly protected with a protecting group, that is, the resin has an ester bond caused to generate carboxylic acid by an acid or an ether bond caused to generate alcohol by an acid, and the protecting group is removed by the acid generated from the photo acid generator at the time of the exposure to the aforesaid light, and the resin becomes soluble in a developing solution, so that patterning can be done. In such a photoresist, what causes performance degradation of a graphene device is that a benzene ring or a naphthalene ring formed of carbons (C) having an $sp^2$ bond is π-π stacked with graphene. Therefore, a resin and a photo acid generator that are not π-π stacked with graphene are constituent elements of the photoresist of the arrangement.

In the photoresist of the arrangement, as the resin, a resin not having an aromatic ring is used. Specifically, a resin containing at least one selected from the group consisting of polyacrylic acid, polymethacrylic acid, a cycloolefin-maleic anhydride copolymer, polycycloolefin, and a vinyl ether-maleic anhydride copolymer and having a protecting group which protects part of its hydrophilic portion, that is, having an ester bond which is caused to generate carboxylic acid by an acid or an ether bond which is caused to generate alcohol by an acid is used. According to the photoresist using such a resin, the resin does not have the aromatic ring and thus can be prevented from being $\pi$-$\pi$ stacked with graphene, making it possible to reduce performance degradation of a graphene device ascribable to the resin.

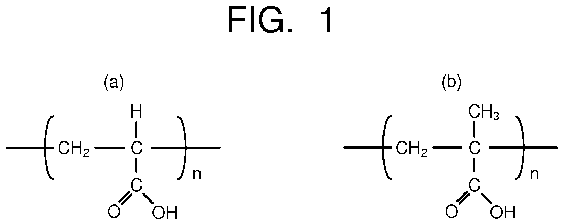

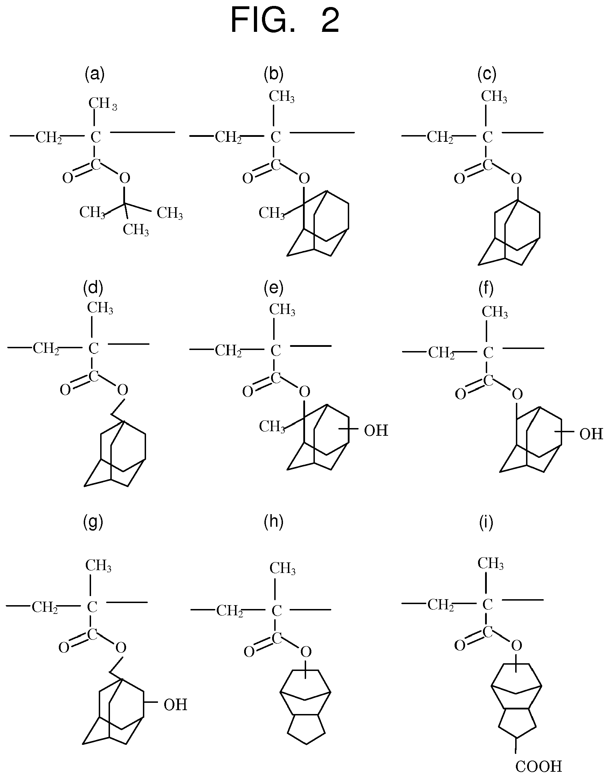

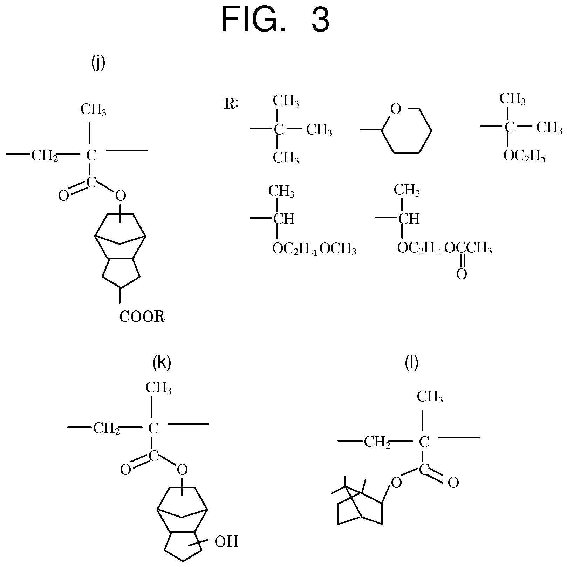

The resin of the photoresist of the arrangement will be described in detail. First, an example of a base resin forming the resin of the photoresist is polyacrylic acid (Fig. 1(a)) or polymethacrylic acid (Fig. 1(b)) illustrated in Fig. 1. In order to make the photoresist function as a resist, an about several 10% unit in which a carboxylic acid portion of polyacrylic acid or polymethacrylic acid is substituted by a protecting group is introduced into a polymer chain. This is a first example of the resin of the photoresist. An introduction amount of the unit substituted by the protecting group is preferably not less than 10 mol% nor more than 50 mol% of the polymer chain. The exposure causes the photo acid generator to generate an acid, and the acid serves as a catalyst to remove the protecting group, so that carboxylic acid is generated. Consequently, the resin becomes soluble in a developing solution. Examples of the unit in which a group serving as the protecting group is introduced are illustrated in Fig. 2 and Fig. 3, taking polymethacrylic acid as an example. Only difference in the case of polyacrylic acid is that the methyl group bonded to C of a main chain is replaced by hydrogen, and the other structure is the same.

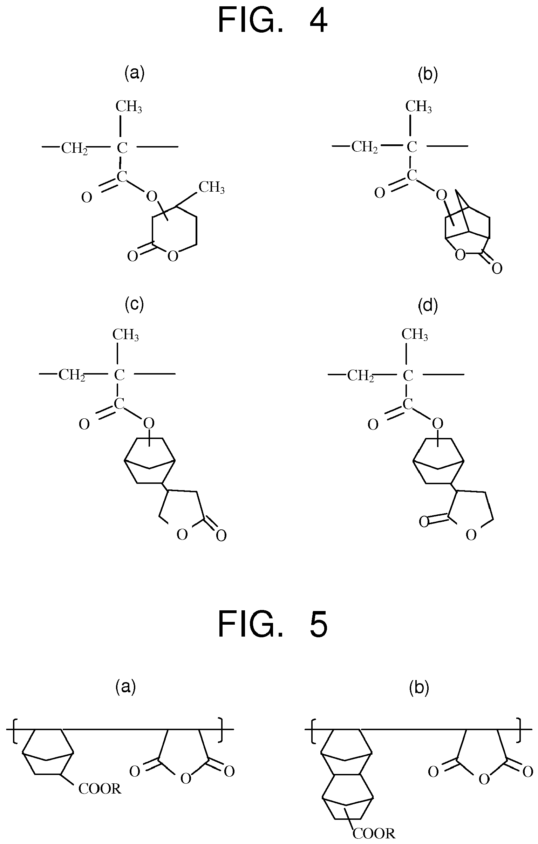

Polyacrylic acid and polymethacrylic acid have characteristics of being higher in etching resistance than other resins. On the other hand, because of their high hydrophobic properties, polyacrylic acid and polymethacrylic acid have a disadvantage of low adhesion. It is effective to introduce a lactone into the resin for the purpose of improving hydrophilic properties of polyacrylic acid and polymethacrylic acid to enhance their adhesion and for the purpose of improving a dissolution contract at the time of the developing. Fig. 4 illustrates examples of a unit having a lactone copolymerized with polyacrylic acid or polymethacrylic acid.

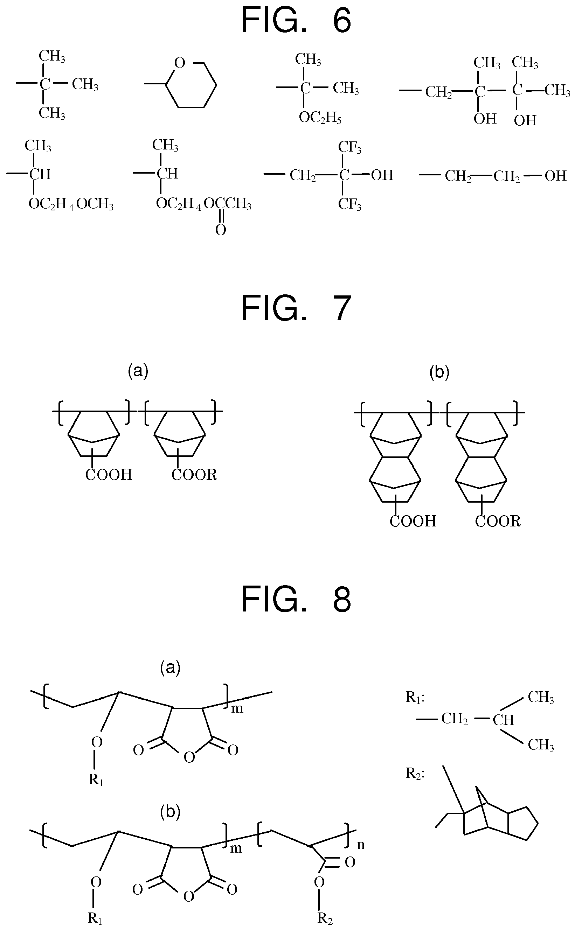

A second example of the resin include alternating copolymers of cycloolefin-maleic anhydride (COMA) illustrated in Fig. 5. Fig. 5(a) is an example where cycloolefin is norbornane, and Fig. 5(b) is an example where cycloolefin is tetracyclododecane. In the structural formulas illustrated in Fig. 5, R is a protecting group. The protecting group R is removed by the acid generated from the photo acid generator, so that carboxylic acid is generated, and the resin becomes soluble in the developing solution. Fig. 6 illustrates examples of the protecting group R in COMA.

A COMA-based resin has a high hydrophilic property and has good affinity with an oxide film. Further, it has a high dissolution contrast at the time of the developing. However, the COMA-based resin is low in etching resistance, and in addition, it is readily hydrolyzed because of an anhydride ring that it contains, and thus some measure needs to be taken for its preservation stability. Incidentally, since graphene itself has a high etching property, very high etching resistance is not required.

A third example of the resin is polycycloolefin whose main chain is formed of cycloolefin as illustrated in Fig. 7. Examples of cycloolefin include norbornane illustrated in Fig. 7(a) and cyclododecane illustrated in Fig. 7(b). They each have carboxylic acid, and part thereof is a substituent (-COOR) substituted by a protecting group. Polycycloolefin contains a unit having the substituent (-COOR) in which part of carboxylic acid is substituted by the protecting group. In this case, R is the protecting group, and the protecting group R is removed by the acid generated from the photo acid generator, as in the other resins. Examples of the protecting group R in polycycloolefin include the same groups as those of the protecting group R in COMA illustrated in Fig. 6.

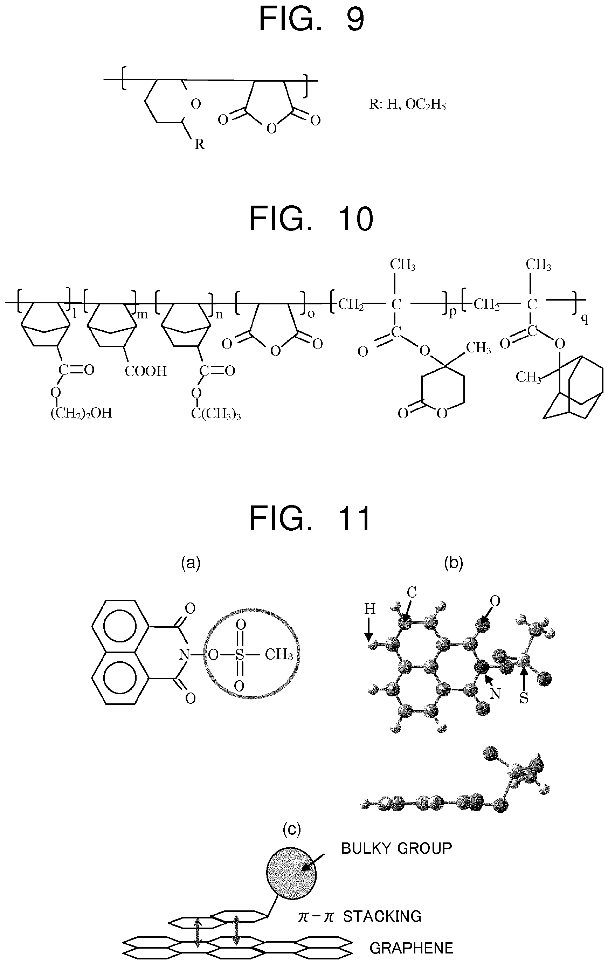

Examples of a fourth example of the resin include vinyl ether-maleic anhydride copolymers (VEMA) illustrated in Fig. 8. Fig. 8(a) illustrates a basic structure of VEMA. A ternary compound system in which a polyacrylic unit is introduced to VEMA for the purpose of improving etching resistance may be used (Fig. 8(b)). In VEMA illustrated in Fig. 8, portions corresponding to an R1 group and an R2 group are protecting groups. Heating in the presence of an acid removes the protecting group R1 to convert a vinyl ether portion into alcohol. The heating removes the protecting group R2 to convert an acrylic acid portion into carboxylic acid. Fig. 9 illustrates another example of a vinyl ether-maleic anhydride copolymer portion. VEMA has a high hydrophilic property and has good affinity with an oxide film. Similarly to the COMA-based resin, it requires some measure for etching resistance and preservation stability.

As described above, the resin systems constituting the resin of the photosensitive composition have their own merits and demerits and thus it is preferable that they are appropriately selected for use according to the intended use or the like. Further, in order to compensate for the demerits of the resin systems, it is also possible to use a hybrid polymer in which a plurality of resin systems are combined. For example, as illustrated in Fig. 10, a hybrid resin of a methacrylic resin that contains a polyacrylic acid-based unit, a polycycloolefin unit, and a maleic anhydride unit, a COMA-based resin, and a polycycloolefin resin, is also usable, for instance.

Next, the photo acid generator of the photoresist will be described. The photo acid generator is a component that generates an acid when absorbing exposure light. When the exposure light is light with a wavelength of not less than 300 nm not more than 500 nm (a g-line (436 nm wavelength) or an i-line (365 nm wavelength) of a halogen lamp or a mercury lamp), it is effective to have a naphthalene ring. When the exposure light is KrF excimer laser light (248 nm wavelength), it is effective to have a benzene ring. However, an aromatic ring such as a naphthalene ring and a benzene ring is $\pi$-$\pi$ stacked with graphene when capable of coming close to the graphene. Fig. 11 illustrates an example thereof.

Fig. 11(a) illustrates an example of the structure of a photo acid generator that absorbs light with a 300 to 500 nm wavelength. Fig. 11(b) illustrates the most stable structure that its molecule can take. In Fig. 11(b), the upper drawing is a view of the molecule seen from above, and the lower drawing is a view of the molecule seen from side. The circled portion in Fig. 11(a) is a bulky group. The photo acid generator illustrated in Fig. 11 is in the most stable state when the bulky group is present in a direction deviating from a surface made by the naphthalene ring as illustrated in Fig. 11(b). Even in a case where the bulky group is thus contained, if the formation position of the bulky group thus deviates from the surface made by the naphthalene ring, the naphthalene ring is capable of coming close to graphene as illustrated in Fig. 11(c) and accordingly the $\pi$-$\pi$ stacking can be formed between the naphthalene ring and the graphene.

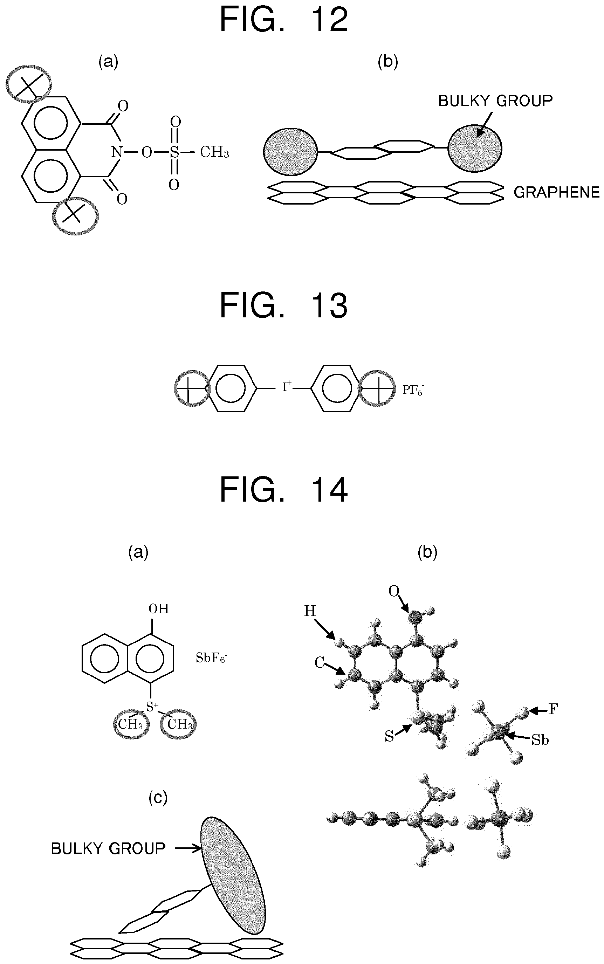

Therefore, in the photo acid generator used in the photoresist of the arrangement, a substance having a naphthalene ring or a benzene ring is used, and in addition, a bulky group is bonded to a carbon of the naphthalene ring or the benzene ring. Fig. 12 illustrates a first example of the photo acid generator used in the photoresist of the arrangement. Fig. 12(a) is a view illustrating a structural formula of the photo acid generator of the first example and Fig. 12(b) is a view illustrating a relation between the aromatic ring and graphene in the photo acid generator of the first example. The photo acid generator illustrated in Fig. 12 is a substance in which t-butyl groups (the circled portions in Fig. 12(a)) are bonded as the bulky groups to carbon atoms of the naphthalene ring of the photo acid generator illustrated in Fig. 11. The t-butyl groups each have a carbon atom to which three methyl groups are bonded, that is, have a tertiary carbon atom.

In the photo acid generator illustrated in Fig. 12, since the three methyl groups of the t-butyl group and the carbon of the naphthalene ring take a tetrahedral structure around the tertiary carbon, the t-butyl groups each have a shape protruding from a surface formed by the naphthalene ring. This can prevent the naphthalene ring from coming close to the graphene as illustrated in Fig. 12(b). In the naphthalene ring, bonding positions of the t-butyl groups are not limited to the positions illustrated in Fig. 12(a), but the t-butyl group only needs to be bonded to at least one carbon atom, preferably two carbon atoms, out of carbon atoms of the naphthalene ring to which imidyl sulfonic acid is not bonded. It should be noted that the t-butyl group is a representative example of an organic group having the tertiary carbon, and the tertiary carbon bonded to the carbon of the naphthalene ring or the benzene ring is not limited to that of the t-butyl group.

The naphthalene ring has an sp$^2$ bond. The photo acid generator of the arrangement has the bulky group deviating from the surface formed by the naphthalene ring, which makes the naphthalene ring floated by steric hindrance to prevent it from coming close to the graphene. As a result, the naphthalene ring does not absorb on the graphene and can be prevented from contaminating the graphene. Since the tertiary carbon of the t-butyl group has an sp$^3$ bond, the three methyl groups and the carbon of the naphthalene ring take the tetrahedral structure. Accordingly, the t-butyl group protrudes from the surface formed by the naphthalene ring, preventing the graphene and the naphthalene ring from coming close to each other. Therefore, it is only necessary that the bulky group has the tertiary carbon and the tertiary carbon is bonded to the naphthalene ring, and the bulky group is not limited to the t-butyl group. For example, part of the butyl group may be substituted, and for example, may be fluorinated. A bulky group may be further bonded to the tertiary carbon, and an alicyclic group such as an adamantyl group or a norbornene group may be bonded. A functional group other than the group having the tertiary carbon like the t-butyl group may be further bonded to the carbon of the naphthalene ring.

In the structure in Fig. 12, the t-butyl groups are bonded to two carbons of the naphthalene ring respectively to prevent the naphthalene ring from coming close to the graphene, but this structure is not restrictive. It is also possible to prevent the naphthalene ring from coming close to the graphene, by bonding the group (bulky group) having the tertiary carbon such as the t-butyl group to one carbon of the naphthalene ring to thereby prevent the naphthalene ring from being parallel to the graphene. In such a case, the positions of the naphthalene ring having the bulky group and the graphene are arranged as illustrated in Fig. 14(c) to be described later. Fig. 14 illustrates a photo acid generator in which, instead of the group having the tertiary carbon, a group having sulfur (S) to which two carbons are bonded is introduced to a naphthalene ring, and a positional relation between the group having sulfur and the graphene is same as that between the naphthalene ring having the bulky group and the graphene.

In Fig. 12, since light to be used is light with a wavelength of not less than 300 nm nor more than 500 nm, the description is given using the photo acid generator having the naphthalene ring, but in a case where KrF excimer light is exposure light, a benzene ring is effective for light absorption. Accordingly, in the case where the KrF excimer light is used as the exposure light, a substance having a benzene ring to which a bulky group such as a group having a tertiary carbon is bonded is effective as the photo acid generator, and in this case, the same effect can be also obtained. Fig. 13 illustrates an example of such a photo acid generator. The photo acid generator illustrated in Fig. 13 is a substance in which a t-butyl group (the circled portion in Fig. 13) is bonded to a carbon of a benzene ring of a diphenyliodonium ion, and the same effect as that in Fig. 12(b) can also be obtained in this case. The photo acid generator illustrated in Fig. 13 is made of a cation (cationic portion) and an anion (anionic portion), and the diphenyliodonium ion of the cationic portion has the aforesaid t-butyl group. The anionic portion is a $PF_6^-$ ion.

The bonding position of the t-butyl group is not limited to a para position of the benzene ring of the diphenyliodonium ion. The same effect can be expected as long as the t-butyl group is bonded to at least one carbon of the benzene ring in the diphenyliodonium ion. Considering the steric hindrance, the two benzene rings each preferably have the t-butyl group. The group having the tertiary carbon is not limited to the t-butyl group, and since the same effect can be expected as long as at least one carbon of the benzene ring is bonded to the tertiary carbon, part of the methyl group in the butyl group may be substituted or may be, for example, fluorinated. A bulky group may be further bonded to the tertiary carbon, and an alicyclic group such as an adamantyl group or a norbornene group may be bonded. A functional group other than the group having the tertiary carbon like the t-butyl may further be bonded to the benzene ring.

In the description here, the diphenyliodonium ion is taken as an example of the cationic portion of the photo acid generator, but the cationic portion is not limited to this. For example, in a photo acid generator having a triphenyl sulfonium ion as the cationic portion, by bonding a group having a tertiary carbon to the carbon of the benzene ring, it is also possible to obtain the same effect. By bonding a bulky group such as the group having the tertiary carbon to the benzene ring of at least one phenyl group out of three phenyl groups of the triphenyl sulfonium ion, preferably to each of the benzene rings of the three phenyl groups, it is possible to prevent the benzene ring from coming close to the graphene to inhibit the π-π stacking of the benzene ring with the graphene surface.

In the above, the bulky group whose tertiary carbon is bonded to the carbon of the benzene ring or the naphthalene ring is described as an example. However, the bulky group is not limited to the group having the tertiary carbon, and a secondary carbon of an isopropyl group or an isobutyl group having a side chain and not being straight-chained, a sec-butyl group, an isopentyl group, a sec-pentyl group, a 3-pentyl group, an isohexyl group, or the like may be bonded to the carbon of the benzene ring or the naphthalene ring. Alternatively, a primary carbon bonded to an alicyclic group such as an adamantyl group or a norbornene group may be bonded. In the above, the example where the plural groups each having the tertiary carbon are bonded is described. However, the bulky group is not limited to the group having the tertiary group, but an isopropyl group or an isobutyl group having a side chain and not being straight-chained, a sec-butyl group, an isopentyl group, a sec-pentyl group, a 3-pentyl group, an isohexyl group, or the like is also usable. Further, an alicyclic group such as an adamantyl group or a norbornene group may be used.

Next, a photo acid generator of a different type from the aforesaid photo acid generator in which the bulky group such as the t-butyl group is bonded to at least one carbon of the naphthalene ring or the benzene ring will be described. Fig. 14 illustrates an example thereof. In this case, the photo acid generator is composed of a cationic portion and an anionic portion. The cationic portion of the photo acid generator has a sulfonium ion, and a sulfur (S) atom of the sulfonium ion is bonded to a naphthalene ring. A group containing this sulfur bonded to two carbons functions as a bulky group. In the above case where the sulfur is bonded to at least one carbon of the naphthalene ring or the benzene ring and the sulfur is bonded to the two carbons, it is also possible to inhibit the naphthalene ring or the benzene ring from being π-π stacked with the graphene surface as in the case where the tertiary carbon is bonded to at least one carbon of the naphthalene ring or the benzene ring.

Fig. 14(a) illustrates a structure in which two methyl groups are bonded to sulfur. Since the sulfur is an ion ($S^+$), a structure in which the methyl groups protrude to the outside of a surface formed by the naphthalene ring as illustrated in Fig. 14(b) is stable. In Fig. 14(b), the upper drawing is a view of a photo acid generator molecule seen from above, and the lower drawing is a view of the photo acid generator molecule seen from side. Since the two methyl groups bonded to the sulfur protrude to the outside of the surface formed by the naphthalene ring, the naphthalene ring is not able to come close to the graphene in this case either, and the π-π stacking of the naphthalene ring and the graphene surface is unlikely to occur. Therefore, no resist residue occurs on the graphene, making it possible to reduce performance degradation of a graphene device. Fig. 14(c) illustrates a conceptual view of this case. The structure in which the group protruding to the outside of the naphthalene ring is bonded only to one side of the naphthalene ring also prevents the naphthalene ring and the graphene from coming close to each other.

In the above-described photo acid generator, the cationic portion has the sulfonium ion, and since the state where the two portions (groups having carbons) bonded to the sulfur and not bonded to the naphthalene ring are oriented to the outside of the naphthalene ring is stable, it is possible to prevent the graphene and the naphthalene ring from coming close to each other. In obtaining such an effect, the carbons bonded to the sulfur are not limited to the carbons of the methyl groups. The groups bonded to the sulfur may be partly substituted methyl groups, for example, fluorinated methyl groups, or may be alkyl groups other than the methyl groups. A functional group other than the group containing the sulfur may be further bonded to the naphthalene ring.

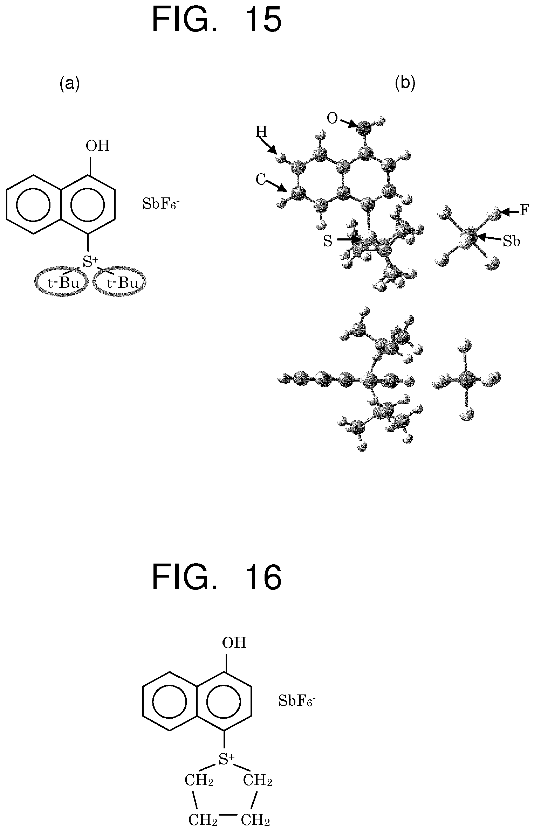

In the above, the group having the sulfur to which the two methyl groups are bonded is a substituent of the naphthalene ring, but the substituent is not limited to this. The groups bonded to the sulfur may be groups bulkier than the methyl groups. For example, a secondary carbon of an ethyl group, an n-propyl group, an isopropyl group or an isobutyl group having a side chain and not being straight-chained, a sec-butyl group, an isopentyl group, a sec-pentyl group, a 3-pentyl group, an isohexyl group, or the like may be bonded to the carbon of the benzene ring or the naphthalene ring. A primary carbon bonded to an alicyclic group such as an adamantyl group or a norbornene group may be bonded. Further, in a photo acid generator illustrated in Fig. 15, groups bonded to sulfur are not methyl groups but t-butyl groups. Fig. 15(b) illustrates a stable structure, the upper drawing being a view of a photo acid generator molecule seen from above and the lower drawing being a view of the photo acid generator molecule seen from side. In this case, the two t-butyl groups are arranged symmetrically outside the surface formed by the naphthalene ring to be in the state illustrated in Fig. 14(c), preventing the naphthalene ring and the graphene from coming close to each other to make their $\pi$-$\pi$ bonding unlikely to occur. Therefore, no resist residue occurs on the graphene, making it possible to reduce performance degradation of the graphene device.

When the above-described photo acid generator is seen from a different angle, the plural bulky groups (here, the groups each having the tertiary carbon as an example) such as the t-butyl groups are included in the substituent of the naphthalene ring, and accordingly the bulky groups are oriented to the outside of the surface made by the naphthalene ring, which is a stable structure. It is seen that this structure prevents the graphene and the naphthalene ring from coming close to each other. That is, as long as the substituent of the naphthalene ring includes not only the sulfonium ion but also the plural bulky groups such as the t-butyl groups, it is possible to prevent the naphthalene ring and the graphene from coming close to each other.

Further, as the bulky group, a case where carbons bonded to sulfur form a ring as illustrated in Fig. 16 is also effective. In this case where two carbons are bonded to the sulfur bonded to a naphthalene ring and these carbons form a ring structure, it is also possible to prevent the naphthalene ring and the graphene from coming close to each other. Here, the ring having the four carbons is taken as an example, but the number of the carbons forming the ring structure may be more. Further, the example where the two carbons are bonded to the sulfur bonded to the naphthalene ring is described in the above, but the same structure may be applied to a photo acid generator having a benzene ring instead of the naphthalene ring, and the same effect is also obtained in this case.

As described above, the photo acid generator contained in the photoresist of the arrangement is formed of a substance having a naphthalene ring or a benzene ring, and for example, has a structure in which at least one carbon atom of the naphthalene ring or the benzene ring is bonded to a tertiary carbon atom, or to a secondary carbon of a group having a side chain, or to a primary carbon bonded to a cyclic group, a structure in which it has a naphthalene ring or a benzene ring, a group bonded to a carbon atom of the naphthalene ring or the benzene ring contains a plurality of bulky groups, in particular, contains a plurality of tertiary carbon atoms, or contains a plurality of groups each having a side chain, or contains a plurality of cyclic groups, or a structure in which at least one carbon atom of the naphthalene ring or the benzene ring is bonded to sulfur atom and the sulfur atom is bonded to two carbon atoms. The photo acid generator having such a molecular structure make it possible to inhibit the $\pi$-$\pi$ bonding of the naphthalene ring or the benzene ring in the molecular structure to the graphene Therefore, using the photoresist containing such a photo acid generator and containing the aforesaid resin not having the aromatic ring makes it possible to prevent the occurrence of the resist residue on the graphene after the patterning step and reduce performance degradation of the graphene device.

In the case where the photo acid generator in the photoresist of the arrangement has the cationic portion and the anionic portion, the cationic portion has the naphthalene ring or the benzene ring. As an example of the anionic portion, $SbF_6^-$ and $PF_6^-$ are cited, but the anionic portion is not limited to these. As the anionic portion, $CF_3SO_3^-$, $C_4F_8SO_3^-$, $C_8F_{17}SO_3^-$, or the like is also usable. These are selected for the purpose of adjusting resist properties such as the intensity of an acid generated after the light irradiation, and various kinds of generally known anionic ions are usable.

A basic fabrication method of the photoresist of the arrangement is to dissolve the aforesaid resin and photo acid generator in a solvent. As the solvent, propylene glycol monomethyl ether acetate, propylene glycol monomethyl ether, propylene glycol monoethyl ether, propylene glycol monopropyl ether, $\gamma$-butyrolactone, 2-heptanone, ethyl lactate, or the like is used. These are selected for the purpose of not only dissolving the resin and the photo acid generator but also obtaining desired coating properties. As for their mixture ratio, for example, the resin whose ratio is within a 1 to 40% by weight to the solvent is dissolved, and the photo acid generator whose ratio is several %, roughly 5% or less to the resin component is dissolved. The photoresist fabricated with such a weight ratio make it possible to obtain favorable resist properties and coating properties.

The photoresist of the arrangement allows the exposure using light with a wavelength of not less than 300 nm nor more than 500 nm (a g-line (436 nm wavelength) or an i-line (365 nm wavelength) of a mercury lamp light source) or KrF excimer laser light with a 248 nm wavelength, and is prevented from contaminating the graphene, based on the aforesaid combination of the resin and the photo acid generator. This enables the low-cost and efficient fabrication of a high-performance graphene device. Incidentally, in an ArF resist for exposure using an ArF excimer laser light with a 193 nm wavelength, an alicyclic resin not containing an aromatic ring, or the like is used as its resin in order to reduce the absorption of the exposure light. However, the ArF resist is not sensitive to light of which a wavelength is not less than 300 nm nor more than 500 nm. This is because its photo acid generator does not have the absorption and does not generate an acid. Therefore, this resist is different from the photoresist of the arrangement.

(Second Embodiment/Method of Manufacturing Graphene Device)

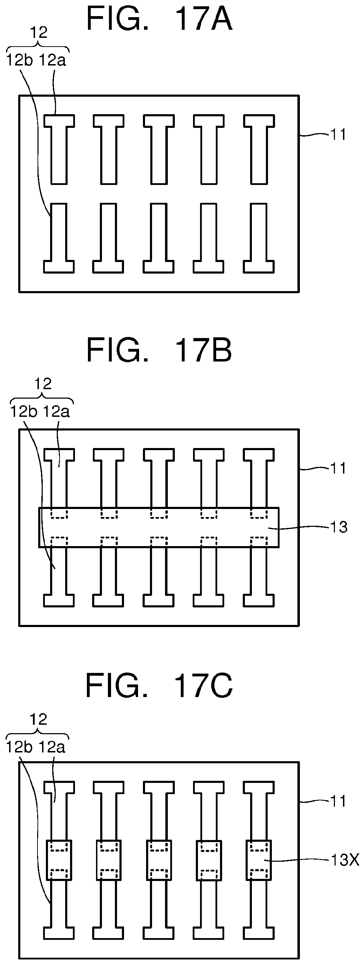

Next, a method of manufacturing a graphene device of an arrangement will be described with reference to Figs. 17A to 17C. Figs. 17A to 17C illustrate steps of manufacturing a graphene field-effect transistor (GFET) using the photoresist of the first arrangement, as an example of the method of manufacturing the graphene device. The graphene FET (GFET) is used as a high-sensitivity gas sensor, for instance. It should be noted that GFET is an example of the graphene device, and the graphene device is not limited to this.

As illustrated in Fig. 17A, on a Si substrate 11 having a thermal Si oxide film on its front surface side and having back gate electrodes on its rear surface side, a plurality of electrode patterns 12 each having a pair of electrodes 12a, 12b are formed. Next, as illustrated in Fig. 17B, graphene 13 is transferred onto the Si substrate 11 in a manner that gaps between the pairs of electrodes 12a, 12b in the plural electrode patterns 12 are covered with the graphene. For trimming (patterning) the graphene 13 illustrated in Fig. 17C, the photoresist of the first arrangement is used.

Specifically, as is done in an ordinary chemically amplified resist process, the photoresist of the first arrangement is applied on the substrate 11 and is baked at a predetermined temperature (soft bake). The baked photoresist film is exposed to light with a wavelength of not less than 300 nm nor more than 500 nm (a g-line (436 nm wavelength) or an i-line (365 nm wavelength) of a mercury lamp light source)) or KrF excimer laser light with a 248 nm wavelength through a photomask. After exposure, the photoresist is baked at a predetermined temperature (post exposure bake), and thereby, the photo acid generator generates an acid. A desired area of the photoresist becomes soluble by the generated acid. Thereafter, the photoresist film is developed into a resist pattern using, for example, a tetramethylammonium hydride aqueous solution (TMAH aqueous solution). Next, with the resist pattern used as a mask, etching of the graphene 13 with, for example, $O_2$ plasma is performed to remove unnecessary portions of the graphene 13.

Thereafter, the resist pattern (photoresist film) is stripped off using, for example, N,N-dimethylacetamide or N-methylpyrrolidinone (NMP), whereby sheets of patterned graphene 13X as illustrated in Fig. 17C are fabricated. In this manner, GFET in which the sheets of thus patterned graphene 13X serve as channels is fabricated. The electrodes 12a are sources and the electrodes 12b are drains. In the aforesaid stripping step of the resist pattern, since the $\pi$-$\pi$ stacking of the photoresist of the arrangement with the graphene is prevented, it is possible to prevent the residue from occurring after the resist pattern is stripped off. This accordingly reduces performance degradation and so on of GFET due to the resist residue, enabling the low-cost and efficient fabrication of the high-performance GFET.

The above-described arrangement is the example where the resist pattern is used as the etching mask of the graphene, but the photoresist of the arrangement can be effectively used for other purposes. For example, in a case where a pattern is formed on graphene, though the graphene is not a processing target, and the pattern forming is performed using the pattern as a mold, the use of the photoresist of the arrangement also makes it possible to reduce the contamination of the graphene.

For example, in forming similar patterns to those of the above-described arrangement, the electrode patterns are sometimes formed after the graphene is first transferred onto the Si oxide film-substrate. Specifically, after the graphene is transferred onto the Si oxide film-substrate, a base film soluble in a developing solution and the photoresist of the arrangement are formed. When the photoresist of the arrangement is heated and thereafter exposed and developed, the base film dissolves in the developing solution after the resist pattern is formed. Using a development condition under which the base film is set back from the photoresist, forms the photoresist into an eaves shape. On such a photoresist, electrode metals (for example, Ni and Au) are deposited in vacuum. Thereafter, lift-off that removes the base film and the photoresist together with the metals, using a stripping solution (developer) such as NMP is performed to form the electrode patterns. Even if the graphene and the photoresist come into contact with each other during the development, the photoresist of the arrangement does not approach the graphene so closely as to be $\pi$-$\pi$ stacked with the graphene, making it possible to prevent the contamination of the graphene.

In the above-described arrangement, the example where the photoresist of the arrangement is used to fabricate GFET used in the gas sensor is described, but a graphene device fabricated by using the manufacturing method of the arrangement is not limited to this. In the case of the gas sensor, the photoresist of the arrangement is applicable to any of various kinds of structures, and the photoresist of the arrangement is usable for trimming the graphene in this case. For example, the photoresist of the arrangement is also effective for fabricating graphene sensors such as a sensor in which gas molecules adsorb on graphene of channel portions of GFET and a sensor in which an organic substance that captures gas molecules is installed on graphene of channel portions by being $\pi$-$\pi$ bonded to the graphene through a pyrene ring.

In the former, a substance serving as an electron donor or an electron acceptor, such as tetrafluorohydroquinone, tetrafluoro-tetracyanoquinodimethane, or polyethyleneimine or a metal particle of Pt, Pd, Al, or the like is adsorbed. In the latter, a pyrene derivative having a group that reacts with a substance to be sensed is used, and a sensing probe is installed on a graphene surface, by making a pyrene portion of the pyrene derivative $\pi$-$\pi$ bonded to the graphene.

Further, not only in a gas sensor, but also in a liquid phase sensor having a pool in a channel portion and performing sensing in a solution, for example, in a DNA sensor or a protein sensor, a sensing probe is also formed on a graphene surface. This makes it possible to improve the sensitivity of the sensor and selectively identify a substance to be sensed by the sensing probe. Further, the substance to be sensed is not limited to $NH_3$ and $NO_2$ which will be described later, but the graphene device is also effective for detecting gas that industrially needs to be detected, such as $CO_2$ or hydrogen, organic phosphoric acid-based harmful gas such as sarin, tabun, or soman, and a specific substance used for cancer exhalation diagnosis, and if the sensor is a liquid-phase sensor, a virus, for example, a human-infectious influenza virus, or the like. In any of these cases, since graphene with less performance degradation due to contamination can be used as a channel, it is possible to fabricate a graphene FET sensor excellent in performance.

Further, a graphene device is also used in an optical frequency mixer, an optical communication modulator, a photodetector, an oscillator, and the like as optical communication devices. In such graphene devices, the photoresist of the arrangement is also usable for forming the graphene shape. Further, the resist of the present invention is also effective for an electronic device, and is applicable also to a switching element that can achieve an on-off current value ratio of $10^5$. Besides, the photoresist of the arrangement is effective for a graphene device manufacture having a step of graphene patterning or the like.

**EXAMPLES**

Next, specific examples and their evaluation results will be described.

(Example 1, Comparative Example 1)

First, a thermal Si oxide film with a 285 nm thickness is formed on an n-type highly-doped Si substrate. An oxide film on a rear surface is stripped off, and metal films, here, 20 nm-thick Ti and 100 nm-thick Ag are deposited to form a back gate electrode. Next, a resist pattern serving as an electrode pattern is formed on the Si oxide film using an i-line resist. With the resist pattern used as a mold, electrode metals are deposited in vacuum. Here, after 10 nm-thick Ni is deposited on the Si oxide film, 20 nm-thick Au is deposited. The resultant is immersed in a stripping solution containing N-methylpyrrolidinone (NMP) as a main material, whereby the unnecessary metals together with the resist are lifted off to form the electrode patterns as illustrated in Fig. 17A.

Next, graphene is transferred. As the graphene, one fabricated on a Cu foil by a CVD method is used. Polymethyl methacrylate (PMMA) is applied on the graphene surface to protect the surface. Since coarse graphene is on a rear surface of the Cu foil, the coarse graphene is removed with $O_2$ plasma. Thereafter, the Cu foil with the graphene is immersed in a Cu stripping solution, so that Cu is dissolved. Here, ammonium peroxodisulfate is used. The graphene is scooped by the Si substrate on which the electrodes is formed, and the graphene is transferred onto the substrate as illustrated in Fig. 17B.

The photoresist of the arrangement is used for trimming the graphene. In the example 1, a methacrylic resin having the protecting group illustrated in Fig. 2(b) and the photo acid generator illustrated in Fig. 14(a) are used. A solvent containing 60% propylene glycol monomethyl ether acetate and 40% propylene glycol monomethyl ether is used, and an amount of the methacrylic resin is adjusted to 10% by weight to the solvent and an amount of the photo acid generator is adjusted to 1% by weight to the resin. As is done in an ordinary resist process, the resist is applied on the substrate by spin coating and is baked at 130°C for 90 seconds. This is exposed, using a mercury halogen lamp. After exposure, the resist is baked at 130°C for 90 seconds. As a mask, a Cr mask is used. This is developed in a tetramethylammonium hydride aqueous solution (TMAH) to be patterned. With the above resist pattern used as a mask, the graphene is etched with $O_2$ plasma. Thereafter, the resist is stripped off by NMP, whereby graphene FET patterns as illustrated in Fig. 17C are obtained.

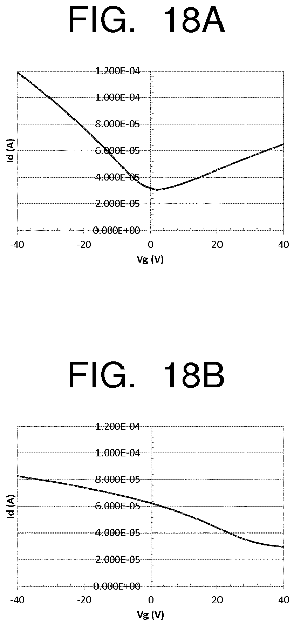

Fig. 18A illustrates an I-V characteristic (a variation characteristic of a drain current Id when a gate voltage Vg is varied under a constant drain voltage) of the graphene FET fabricated in the example 1. Fig. 18B illustrates an I-V characteristic of a graphene FET as a comparative example 1 fabricated in the same manner as in the example 1 except that a commercially available i-line novolac resist is used. Graphene displays polarity since holes and electrons serve as carriers, and in its I-V characteristic, a point where Id is the smallest, that is, a Dirac point appears. Inherently, it is neutral when Vg is 0 V.

As illustrated in Fig. 18B, the Dirac point is not clearly observed in the graphene FET of the comparative example 1 until Vg becomes 40 V. In the graphene FET of the example 1, on the other hand, the Dirac point is observed near substantially 0 V as illustrated in Fig. 18A. Further, the gradient of the I-V characteristic is proportional to mobility, and in the graphene FET of the example 1, the gradient is larger than in the comparative example 1, from which it is seen that the mobility is large in the graphene FET of the example 1.

In a case where the graphene FET fabricated in this manner is used as a gas sensor, gas introduction causes charge transfer, so that the I-V characteristic illustrated in Fig. 18A transfers to left or right according to a gas species. In a case of $NO_2$, it transfers to right, and in a case of $NH_3$, it transfers to left. At this time, if the gradient of the I-V characteristic is large, an Id variation is large even under the same amount of the left or right transfer. Accordingly, the sensitivity improves. That is, by using the photoresist of the arrangement to fabricate the graphene FET, it is possible to improve sensitivity as a sensor.

(Example 2)

A resin that is the COMA-based resin in Fig. 5(a) and whose substituent R is a t-butyl group, and the photo acid generator illustrated in Fig. 15(a) are dissolved in a solvent containing 60% propylene glycol monomethyl ether acetate and 40% propylene glycol monomethyl ether. An amount of the resin is adjusted to 30% by weight to the solvent, and an amount of the photo acid generator is adjusted to 1% by weight to the resin. By using the resultant photoresist, a graphene FET is fabricated in the same manner as in the example 1. In the case, the resist is baked at 90°C for 90 seconds in the soft bake and the post exposure bake. When an I-V characteristic of the fabricated graphene FET is measured, the Dirac point is observed at substantially 0 V as in Fig. 18A. Further, since the gradient of the I-V characteristic is larger than that in Fig. 18B, it is confirmed that the mobility is large.

(Example 3)

The hybrid resin illustrated in Fig. 10 and the photo acid generator illustrated in Fig. 12(a) are dissolved in a solvent containing 60% propylene glycol monomethyl ether acetate, 30% propylene glycol monomethyl ether, and 10% γ-butyrolactone. An amount of the resin is adjusted to 20% by weight to the solvent, and an amount of the photo acid generator is adjusted to 1% by weight to the resin. By using the resultant photoresist, a graphene FET is fabricated in the same manner as in the example 1. In the case, the resist is baked at 110°C for 90 seconds in the soft bake and the post exposure bake. When an I-V characteristic of the fabricated graphene FET is measured, the Dirac point is observed at substantially 0 V as in Fig. 18A. Further, since the gradient of the I-V characteristic is larger than that in Fig. 18B, it is confirmed that the mobility is large.

(Example 4, Comparative Example 2)

In the example 4 and the comparative example 2, an effect of the photo acid generator is described. By using the photoresist containing the photo acid generator of which the naphthalene ring is capable of coming close to graphene as illustrated in Fig. 11(c), and the photoresist containing the photo acid generator of which the naphthalene ring is not capable of coming close to graphene as illustrated in Fig. 14(c), graphene FETs are fabricated , and a I-V characteristic of the fabricated graphene FET and a mobility of graphene calculated from the I-V characteristic is compared between the two graphene FETs. In the manufacturing method of the graphene FET, the processes up to the one for transferring the graphene are the same as the example 1. The photoresist using the trimming process of the graphene is different from that of the example 1. The photoresists using the example 4 and the comparative example 2 are described as follows.

A methacrylic resin containing a lactone illustrated in Fig. 4(a) and having the protecting group illustrated in Fig. 2(b) is used. The monomers are copolymerized so that a unit having the protecting group becomes 20 mol% of the methacrylic resin, and the lactone becomes 5 mol% of the methacrylic resin. A solvent containing 60% propylene glycol monomethyl ether acetate and 40% propylene glycol monomethyl ether is used. An amount of the photo acid generator is adjusted to 1% by weight to the resin.

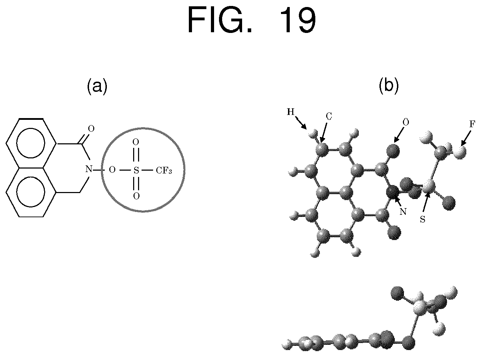

Two types of photo acid generators are prepared. An photo acid generator (NAI-105, manufactured by Midori Kagaku Co., Ltd) of which the naphthalene ring is capable of coming close to graphene is prepared as a photo acid generator of the comparative example 2, and a photo acid generator (NDS-105, manufactured by Midori Kagaku Co., Ltd) of which the naphthalene ring is not capable of coming close to graphene is prepared as a photo acid generator of the example 4. NAI-105 has a structure of which hydrogens of the methyl group illustrated in Fig. 11(a) are substituted by fluorines, and the structure is illustrated in Fig. 19(a). Fig. 19(b) illustrates a stable structure. In Fig. 19(b), the upper drawing is a view of a molecule seen from above and the lower drawing is a view of the molecule seen from side. As in the case with the photo acid generator illustrated in Fig. 11(a), even if the circled portion is a bulky group, an N-O bonded potion is rotatable, and thereby the naphthalene ring of the photo acid generator is capable of coming close to graphene. NDS-105 has a cationic portion which is the same as the cationic portion illustrated in Fig. 14(a) and a $CF_3SO_3^-$ ion as an anionic portion. Since NDS-105 has a structure of which the methyl groups in the cationic portion protrude to the outside of the surface formed by the naphthalene ring, the naphthalene ring is not able to come close to the graphene.

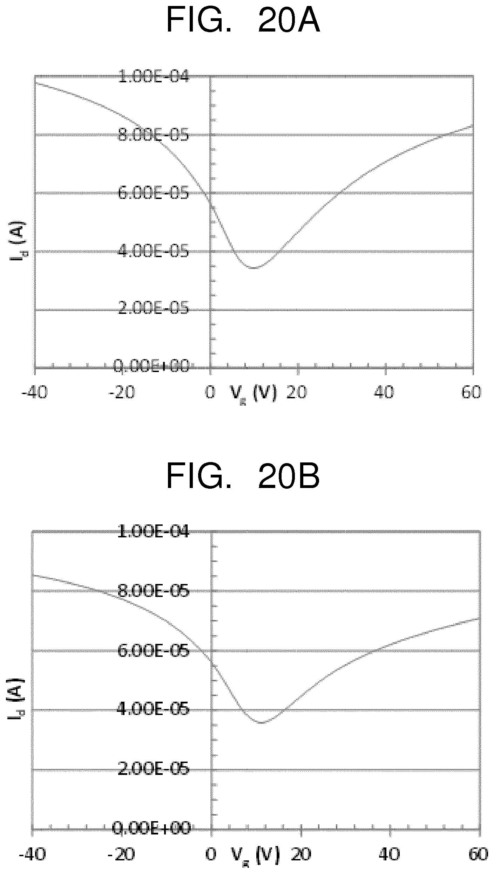

The graphene FETs are fabricated by using the two types of photoresists having different photo acid generators. The process for fabricating the graphene FET by using the photoresist is the same as in the example 1. The I-V characteristics of the graphene FETs are measured. Figs. 20A and 20B illustrate measured results. Fig. 20A illustrates an I-V characteristic of the graphene FET (example 4) fabricated by using NDS-105, and Fig. 20B illustrates an I-V characteristic of the graphene FET (comparative example 2) fabricated by using NAI-105. The gradient of the example 4 is larger than that of the comparative example 2. The gradient corresponds to the mobility, and the mobility is high so the gradient is large. Therefore, it is thought that the deterioration of the graphene by the resist process is suppressed.

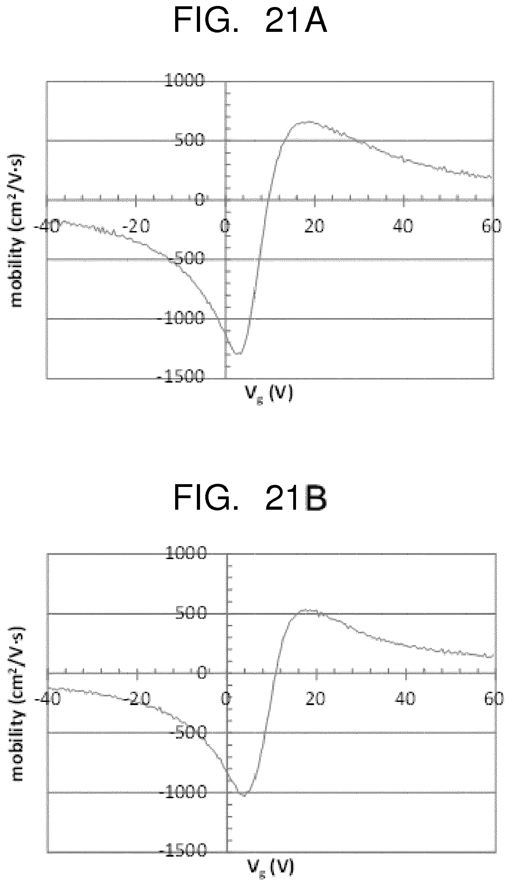

Figs. 21A and 21B illustrate effective mobility calculated from the gradient of I-V characteristic. Fig. 21A illustrates the effective mobility of the example 4 using NDS-105, and Fig. 21B illustrates effective mobility of the comparative example 2 using NAI-105. The effective mobility $\mu$ is calculated by the following expression (1).

$$\mu = L/(W \cdot C_{ox}) \times 1/V_d \times \partial I_d/\partial I_g \quad ... (1)$$

In the expression (1), L is channel length, W is channel width, $V_d$ is drain voltage, $I_d$ is drain current, $V_g$ is gate voltage, $C_{ox}$ is $\varepsilon_0 \cdot \varepsilon_s \times 1/t$ ($\varepsilon_0$: permittivity of vacuum, $\varepsilon_s$: relative permittivity of $SiO_2$, t: thickness of film).

It is seen that a maximum value of the effective mobility in the example 4 using NDS-105 is larger than in the comparative example 2 using NAI-105. It is found from the result that the deterioration of the graphene by using the photoresist containing NDS-105 of which the naphthalene ring is not capable of coming close to the graphene can be suppressed. The reason why the I-V characteristic of the example 4 is difference from that of the examples 1-3 is that the used graphene in the example 4 is difference from the used graphene in the examples 1-3. The CVD graphene of in-house product is used in the examples 1-3, but the CVD graphene manufactured by Graphenea Inc. is used in the example 4.

While certain arrangements of the present invention have been described, these arrangements have been presented by way of example only, and are not intended to limit the scope of the inventions. Indeed, the novel arrangements described herein may be embodied in a variety of other forms; furthermore, various omissions, substitutions and changes may be made without departing from the spirit of the inventions. The inventions described in the accompanying claims and their equivalents are intended to cover such forms or modifications as would fall within the scope and spirit of the inventions.

(Numbered Clauses relating to the arrangements)

1. A photosensitive composition comprising:

a resin containing at least one selected from the group consisting of polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and
a photo acid generator which generates an acid by being irradiated with light with a wavelength of not less than 300 nm nor more than 500 nm or KrF excimer laser light, the photo acid generator containing a substance which has a naphthalene ring or a benzene ring and in which at least one carbon atom of the naphthalene ring or the benzene ring is bonded to a bulky group.

2. The composition according to clause 1, wherein the bulky group contains a tertiary carbon atom, and at least one carbon atom of the naphthalene ring or the benzene ring is bonded to the tertiary carbon atom.

3. The composition according to clause 1, wherein the bulky group contains a tertiary carbon atom, and a substituent bonded to a carbon atom of the naphthalene ring or the benzene ring contains a plurality of the tertiary carbon atoms.

4. A photosensitive composition comprising:

a resin containing at least one selected from the group consisting of polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and
a photo acid generator which generates an acid by being irradiated with light with a wavelength of not less than 300 nm nor more than 500 nm or KrF excimer laser light, wherein:

the photo acid generator is made of a cation and an anion, the cation is a sulfonium ion, and the cation has a naphthalene ring or a benzene ring; and
at least one carbon atom of the naphthalene ring or the benzene ring is bonded to sulfur atom, and the sulfur atom is bonded to two carbon atoms.

5. A method of manufacturing a graphene device, the method comprising:

applying the photosensitive composition according to any one of clause 1 to clause 4 on graphene directly or on a film other than the graphene formed on the graphene;
exposing the photosensitive composition above the graphene by irradiating the photosensitive composition with light with a wavelength of not less than 300 nm nor more than 500 nm or KrF excimer laser light through a photomask;
heating the photosensitive composition;
forming a photosensitive composition pattern by developing the photosensitive composition;
processing the graphene or the film by using the photosensitive composition pattern; and
removing the photosensitive composition pattern.

6. The method according to clause 5, wherein:

the photosensitive composition contains the photo acid generator having the naphthalene ring; and
the photosensitive composition is exposed by being irradiated with the light with the wavelength of not less than 300 nm nor more than 500 nm.

7. The method according to clause 5, wherein:

the photosensitive composition contains the photo acid generator having the benzene ring; and
the photosensitive composition is exposed by being irradiated with the KrF excimer laser light.

8. The method according to any one of clause 5 to clause 7, wherein the graphene device is a graphene FET.

**Claims**

1. A photosensitive composition comprising:

a resin containing at least one selected from the group consisting of polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and
a photo acid generator which generates an acid by being irradiated with light with a wavelength of not less than 300 nm nor more than 500 nm or KrF excimer laser light, the photo acid generator containing a substance which has a naphthalene ring or a benzene ring and in which at least one carbon atom of the naphthalene ring or the benzene ring is bonded to a bulky group.

2. The composition according to claim 1, wherein the bulky group contains a tertiary carbon atom, and at least one carbon atom of the naphthalene ring or the benzene ring is bonded to the tertiary carbon atom.

3. The composition according to claim 1, wherein the bulky group contains a tertiary carbon atom, and a substituent bonded to a carbon atom of the naphthalene ring or the benzene ring contains a plurality of the tertiary carbon atoms.

4. A photosensitive composition comprising:

a resin containing at least one selected from the group consisting of polyacrylic acid, polymethacrylic acid, a cycloolefin-maleic anhydride copolymer, polycycloolefin, and a vinyl ether-maleic anhydride copolymer and having an ester bond which is caused to generate carboxylic acid by an acid or an ether bond which is caused to generate alcohol by an acid; and
a photo acid generator which generates an acid by being irradiated with light with a wavelength of not less than 300 nm nor more than 500 nm or KrF excimer laser light, wherein:

the photo acid generator is made of a cation and an anion, the cation is a sulfonium ion, and the cation has a naphthalene ring or a benzene ring; and
at least one carbon atom of the naphthalene ring or the benzene ring is bonded to sulfur atom, and the sulfur atom is bonded to two carbon atoms.

5. A method of manufacturing a graphene device, the method comprising:

applying the photosensitive composition according to any one of claim 1 to claim 4 on graphene directly or on a film other than the graphene formed on the graphene;
exposing the photosensitive composition above the graphene by irradiating the photosensitive composition with light with a wavelength of not less than 300 nm nor more than 500 nm or KrF excimer laser light through a photomask;
heating the photosensitive composition;
forming a photosensitive composition pattern by developing the photosensitive composition;
processing the graphene or the film by using the photosensitive composition pattern; and
removing the photosensitive composition pattern.

6. The method according to claim 5, wherein:

the photosensitive composition contains the photo acid generator having the naphthalene ring; and
the photosensitive composition is exposed by being irradiated with the light with the wavelength of not less than 300 nm nor more than 500 nm.

7. The method according to claim 5, wherein:

the photosensitive composition contains the photo acid generator having the benzene ring; and
the photosensitive composition is exposed by being irradiated with the KrF excimer laser light.

8. The method according to any one of claim 5 to claim 7, wherein
the graphene device is a graphene FET.

# FIG. 1

(a)

(b)

# FIG. 2

# FIG. 3

(j)

(k)

(l)

# FIG. 4

(a)

(b)

(c)

(d)

# FIG. 5

(a)

(b)

# FIG. 6

# FIG. 7

(a)

(b)

# FIG. 8

(a)

(b)

# FIG. 9

R: H, OC₂H₅

# FIG. 10

# FIG. 11

(a)

(b)

(c)

BULKY GROUP

π–π STACKING

GRAPHENE

# FIG. 12

(a)

(b)

BULKY GROUP

GRAPHENE

# FIG. 13

PF$_6^-$

# FIG. 14

(a)

(b)

OH

SbF$_6^-$

S$^+$

CH$_3$  CH$_3$

O

H

C

S

F

Sb

(c)

BULKY GROUP

# FIG. 15

(a)

(b)

# FIG. 16

# FIG. 17A

# FIG. 17B

# FIG. 17C

# FIG. 18A

# FIG. 18B

# FIG. 19

(a)

(b)

# FIG. 20A

# FIG. 20B

# FIG. 21A

# FIG. 21B

Europäisches
Patentamt

European
Patent Office

Office européen
des brevets

# EUROPEAN SEARCH REPORT

**Application Number**

EP 18 16 2333

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/104563 A1 (ISHIDUKA KEITA [JP] ET AL) 23 April 2009 (2009-04-23) <br> * paragraphs [0005] - [0039], [0444], [0455]; claims 1-13; examples 1-5 * | 1-4 | INV. <br> G03F7/004 <br> G03F7/039 |
| X | US 2010/209827 A1 (OHASHI MASAKI [JP] ET AL) 19 August 2010 (2010-08-19) <br> * paragraphs [0001], [0027] - [0032], [0078] - [0106], [0117] - [0124], [0128] - [0195], [0231] - [0233]; claims 1-16; tables 1-3 * | 1-4 | |
| X | US 2016/131976 A1 (TSUCHIMURA TOMOTAKA [JP] ET AL) 12 May 2016 (2016-05-12) <br> * paragraphs [0015], [0207], [0246], [0442]; claims 1-9; tables 1-9 * | 1-4 | |
| X | EP 3 064 997 A1 (FUJIFILM CORP [JP]) 7 September 2016 (2016-09-07) <br> * paragraphs [0022] - [0026], [0068] - [0199], [0204] - [0260], [0435] - [0476]; claims 1-25; examples 1-26 * | 1-8 | TECHNICAL FIELDS SEARCHED (IPC) <br><br> G03F |

The present search report has been drawn up for all claims

| Place of search | Date of completion of the search | Examiner |
|---|---|---|
| Munich | 25 June 2018 | Mingam, Claudie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 16 2333

This annex lists the patent family members relating to the patent documents cited in the above-mentioned European search report.
The members are as contained in the European Patent Office EDP file on
The European Patent Office is in no way liable for these particulars which are merely given for the purpose of information.

25-06-2018

| Patent document cited in search report | | Publication date | Patent family member(s) | | Publication date |
|---|---|---|---|---|---|
| US 2009104563 | A1 | 23-04-2009 | NONE | | |
| US 2010209827 | A1 | 19-08-2010 | JP | 5368270 B2 | 18-12-2013 |
| | | | JP | 2010215608 A | 30-09-2010 |
| | | | KR | 20100094947 A | 27-08-2010 |
| | | | TW | 201100361 A | 01-01-2011 |
| | | | US | 2010209827 A1 | 19-08-2010 |
| US 2016131976 | A1 | 12-05-2016 | JP | 6097649 B2 | 15-03-2017 |
| | | | JP | 2015022074 A | 02-02-2015 |
| | | | KR | 20160018785 A | 17-02-2016 |
| | | | TW | 201512286 A | 01-04-2015 |
| | | | US | 2016131976 A1 | 12-05-2016 |
| | | | WO | 2015008594 A1 | 22-01-2015 |
| EP 3064997 | A1 | 07-09-2016 | CN | 105683835 A | 15-06-2016 |
| | | | EP | 3064997 A1 | 07-09-2016 |
| | | | JP | 6167016 B2 | 19-07-2017 |
| | | | JP | 2015087609 A | 07-05-2015 |
| | | | KR | 20160064167 A | 07-06-2016 |
| | | | KR | 20170139693 A | 19-12-2017 |
| | | | TW | 201523136 A | 16-06-2015 |
| | | | US | 2016240816 A1 | 18-08-2016 |
| | | | WO | 2015064602 A1 | 07-05-2015 |

EPO FORM P0459

For more details about this annex : see Official Journal of the European Patent Office, No. 12/82